# EUROPEAN PATENT APPLICATION

(11) **EP 4 648 588 A1**
(43) Date of publication of application: **12.11.2025**
(21) Application number: 24756165.7
(22) Date of filing: 06.02.2024
(51) Int. Cl.: H10K 59/122, H10K 50/858, H10K 50/85

(54) **ARRAY SUBSTRATE AND PREPARATION METHOD THEREFOR, AND DISPLAY PANEL AND TERMINAL DEVICE**

(30) Priority: 16.02.2023 CN 202310158564
(71) Applicant: Huawei Technologies Co., Ltd., Shenzhen, Guangdong 518129 (CN)
(72) Inventor: ZHOU, Xiang, Shenzhen, Guangdong 518129 (CN); NI, Huan, Shenzhen, Guangdong 518129 (CN); CHANG, Yiwen, Shenzhen, Guangdong 518129 (CN); CHEN, Dingfu, Shenzhen, Guangdong 518129 (CN)
(74) Representative: Maiwald GmbH
(86) International application number: PCT/CN2024/076373
(87) International publication number: WO 2024/169792

(57) **Abstract**

This application provides an array base plane, a method for preparing an array base plane, a display panel, and a terminal device, and relates to the field of display technologies, so that more high-angle rays can be emitted from a first pixel definition layer and used for display, to improve display brightness. The array base plane has a plurality of sub-pixel regions. The array base plane includes a substrate and a first pixel definition layer disposed on the substrate. The first pixel definition layer is disposed between adjacent sub-pixel regions, and the first pixel definition layer includes a plurality of first protrusions in a direction from any one of the sub-pixel regions to a sub-pixel region adjacent to the any one sub-pixel region.

## Description

This application claims priority to Chinese Patent Application No. 202310158564.7, filed with the China National Intellectual Property Administration on February 16, 2023 and entitled "ARRAY BASE PLANE, METHOD FOR PREPARING ARRAY BASE PLANE, DISPLAY PANEL, AND TERMINAL DEVICE", which is incorporated herein by reference in its entirety.

### TECHNICAL FIELD

This application relates to the field of display technologies, and in particular, to an array base plane, a method for preparing an array base plane, a display panel, and a terminal device.

### BACKGROUND

Organic light-emitting diode (organic light-emitting diode, OLED) displays have many advantages such as light weight, thinness, high contrast, high response speed, flexibility, and foldability. With development and upgrading of a high-dynamic range (high-dynamic range, HDR) technology and demands for outdoor usage scenarios, consumers have increasingly high demands for brightness of display products. Currently, limited by factors such as light-emitting efficiency of a light-emitting material, external quantum efficiency (external quantum efficiency, EQE) of a device, and a size of a pixel definition layer (pixel definition layer, PDL), the OLED displays are to be improved in display brightness.

For example, in a light-emitting device of an OLED display, due to factors such as surface plasmon effect (Surface Plasmon Polariton, SPP) losses of an interface between a cathode and a light-emitting layer and an interface between an anode and the light-emitting layer, a waveguide loss inside the OLED display, and absorption of each film layer in the OLED display, EQE of the OLED display is low. Therefore, how to improve brightness of the OLED display is a problem to be urgently resolved currently.

### SUMMARY

To resolve the foregoing technical problem, this application provides an array base plane, a method for preparing an array base plane, a display panel, and a terminal device, so that more high-angle rays can be emitted from a first pixel definition layer and used for display, to improve display brightness.

According to a first aspect, this application provides an array base plane. The array base plane has a plurality of sub-pixel regions. The array base plane includes a substrate and a first pixel definition layer disposed on the substrate. The first pixel definition layer is disposed between adjacent sub-pixel regions, and the first pixel definition layer includes a plurality of first protrusions in a direction from any one of the sub-pixel regions to a sub-pixel region adjacent to the any one sub-pixel region.

In this application, the first pixel definition layer between the adjacent sub-pixel regions includes the plurality of first protrusions, and the plurality of first protrusions are arranged in the direction from the any one of the sub-pixel regions to the sub-pixel region adjacent to the any one sub-pixel region. Therefore, a surface that is of the first pixel definition layer including the plurality of first protrusions and that is away from the substrate in this application is more uneven than that of a pixel definition layer in a related technology. In this way, when the array base plane is used in a display panel, and a high-angle ray emitted from the any one sub-pixel region is propagated in a waveguide mode through a surface that is of the first pixel definition layer and that is away from the substrate, the ray is more likely to be emitted from the more uneven first pixel definition layer, so that more high-angle rays are emitted from the first pixel definition layer and used for display. This can resolve a problem in a related technology that a high-angle ray propagated in a waveguide mode in a direction parallel to a horizontal plane in the pixel definition layer always cannot be emitted. This improves display brightness of the display panel without increasing power consumption of the display panel.

In some possible implementations, adjacent first protrusions are spaced apart; and in a direction from the substrate to the first pixel definition layer, a thickness of a part that is of the first pixel definition layer and that is located between the adjacent first protrusions is less than a thickness of the first protrusion. For example, the thickness of the part that is of the first pixel definition layer and that is located between the adjacent first protrusions is greater than or equal to 0.

In view of this, in some possible implementations, surfaces that are of the plurality of first protrusions and that are away from the substrate are arc surfaces. Different from another shape, in the direction from the any one of the sub-pixel regions to the sub-pixel region adjacent to the any one sub-pixel region, included angles between countless tangents at all positions of the arc surface and a horizontal direction are different, where all the tangents except one are not parallel to the horizontal direction. In this way, more high-angle rays propagated in the first pixel definition layer in a waveguide mode are emitted from the first pixel definition layer and used for display.

The part that is of the first pixel definition layer and that is located between the adjacent first protrusions is a pit, and a surface that is of the pit and that is away from the substrate is an arc surface. Different from another shape, in the direction from the any one of the sub-pixel regions to the sub-pixel region adjacent to the any one sub-pixel region, included angles between countless tangents at all positions of the arc surface and a horizontal direction are different, where all the tangents except one are not parallel to the horizontal direction. In this way, more high-angle rays propagated in the first pixel definition layer in a waveguide mode are emitted from the first pixel definition layer and used for display.

In some possible implementations, the array base plane further includes a planarization layer and an anode, the planarization layer is disposed between the substrate and the first pixel definition layer, and the anode is located in the sub-pixel region. The planarization layer includes a second protrusion, the second protrusion is disposed between adjacent anodes, a taper angle of the second protrusion is a non-right angle, and a side surface of the second protrusion gradually tilts from the anode to the planarization layer in a direction from the substrate to the planarization layer. The anode extends from the sub-pixel region and the side surface of the second protrusion to a side that is of the second protrusion and that is away from the substrate. In this way, a side surface of the anode may be used as a reflective surface, and some high-angle rays projected onto the side surface of the anode may be reflected by the side surface of the anode to the display panel and used for display, to improve display brightness of the display panel.

In some possible implementations, an overlapping region exists between an orthographic projection of the first protrusion on the substrate and an orthographic projection of the anode adjacent to the first protrusion on the substrate. The array base plane further includes a second pixel definition layer, the second pixel definition layer includes a third protrusion, and the third protrusion is disposed between the adjacent first protrusions. A width of the first protrusion is less than a width of the third protrusion in the direction from the any one of the sub-pixel regions to the sub-pixel region adjacent to the any one sub-pixel region; and a thickness of the first protrusion is less than a thickness of the third protrusion in the direction from the substrate to the first pixel definition layer.

In this way, the first protrusion has a small width and a small thickness, so that a distance between a light-emitting layer and the side surface of the anode can be reduced, to avoid a case in which because the distance between the light-emitting layer and the side surface of the anode is excessively large, some rays cannot be reflected by the side surface of the anode and used for display.

In some possible implementations, the first pixel definition layer and the second pixel definition layer each include a photosensitive material. For example, a material of the first pixel definition layer and a material of the second pixel definition layer are the same as a material of a positive photoresist. Patterns of the first pixel definition layer and the second pixel definition layer may be obtained by using film formation, exposure, and development in a same semiconductor process. In this way, the first pixel definition layer and the second pixel definition layer that have different patterns may be prepared by using a same mask, and an etching process may be omitted.

Specifically, after a pixel definition thin film is formed, the pixel definition thin film is exposed. During exposure, an opening of a mask corresponds to a part of the pixel definition thin film except a to-be-formed first protrusion and a to-be-formed third protrusion. In addition, because the width of the third protrusion is greater than the width of the first protrusion, when the pixel definition thin film is exposed, impact on the to-be-formed first protrusion is greater than impact on the to-be-formed third protrusion, and the thickness of the first protrusion obtained after development is also less than the thickness of the third protrusion. That is, the first pixel definition layer and the second pixel definition layer can be obtained by exposing the pixel definition thin film by using only one mask.

In some possible implementations, there are two first protrusions, there is one third protrusion, and the two first protrusions and the third protrusion are continuously disposed. A surface that is of the first protrusion and that is away from the substrate includes a first surface and an inclined second surface, the first surface is parallel to a horizontal surface, and a surface that is of the third protrusion and that is away from the substrate is connected to the first surface.

The overlapping region exists between the orthographic projection of the first protrusion and the orthographic projection of the anode adjacent to the first protrusion on the substrate, and the anode extends from the sub-pixel region and the side surface of the second protrusion to the side that is of the second protrusion and that is away from the substrate. In this way, the first protrusion also needs to incline from the side surface of the anode to a side that is of the anode and that is away from the substrate, where an inclined surface of the first protrusion is the second surface. In view of this, because a surface that is of the second protrusion in the planarization layer and that is away from the substrate may be a plane, and the first protrusion is disposed on the side that is of the second protrusion and that is away from the substrate, in addition to the inclined second surface, the surface that is of the first protrusion and that is away from the substrate includes the first surface parallel to the horizontal surface.

For a solution in which the plurality of first protrusions are spaced apart, or the plurality of first protrusions are spaced apart and the first protrusion and the third protrusion are also spaced apart, in a process of preparing the first protrusion and the third protrusion by using a same semiconductor process, many patterns need to be patterned, and during mask-based exposure, parts that are of a mask and that correspond to a spacing between the protrusions are an opening. However, in this application, the first protrusion may be obtained based on a pattern of the second protrusion. In addition, because the first surface is parallel to the horizontal plane, and the first surface is connected to the third protrusion, for example, the first protrusion and the third protrusion are prepared by using a half-tone process, and during second exposure, an opening of the mask may correspond to a part other than the third protrusion. Compared with a solution in which the plurality of first protrusions are spaced apart, or the plurality of first protrusions are spaced apart and the first protrusion and the third protrusion are also spaced apart, this solution greatly reduces a quantity of openings in the mask, so that a process yield rate of preparing the first protrusion and the third protrusion can be improved.

In some possible implementations, in the direction from the substrate to the first pixel definition layer, the side surface of the second protrusion tilts in a direction from a light-emitting device to the pixel definition layer. An acute angle between the side surface and a bottom surface of the second protrusion ranges from 5° to 85°. For example, the taper angle of the second protrusion may be 5°, 20°, 45°, 60°, or 85°.

Optionally, the taper angle of the second protrusion may range from 20° to 60°, to avoid a case in which a film layer (for example, a cathode) disposed on a side that is of the first pixel definition layer and that is away from the substrate is broken because the taper angle of the second protrusion is excessively large.

In some possible implementations, the side surface of the second protrusion is in a shape of a sawtooth. In this way, a side surface that is of the anode and that corresponds to the side surface of the second protrusion is also in a shape of a sawtooth, so that efficiency of reflecting a high-angle ray by the anode can be further improved, to improve display brightness of the display panel.

In some possible implementations, in a case in which the array base plane does not include the second pixel definition layer, the array base plane further includes a planarization layer, and the planarization layer is disposed between the substrate and the first pixel definition layer. In a case in which the thickness of the part that is of the first pixel definition layer and that is located between the adjacent first protrusions is greater than 0, the planarization layer includes a fourth protrusion and/or a groove, and an orthographic projection of the fourth protrusion and/or an orthographic projection of the groove on the substrate are/is located between orthographic projections of the adjacent first protrusions on the substrate. In this way, if some high-angle rays passing through the first protrusion are still not emitted from the first pixel definition layer and used for display, the some high-angle rays may further propagate along the fourth protrusion and/or the groove of the first pixel definition layer, break a horizontal propagation angle again by using the fourth protrusion and/or the groove, and are emitted from the display panel and used for display, to further improve display brightness of the display panel.

In some possible implementations, a surface that is of the fourth protrusion and/or the groove and that is away from the substrate is an arc surface. Different from another shape, in the direction from the any one of the sub-pixel regions to the sub-pixel region adjacent to the any one sub-pixel region, included angles between countless tangents at all positions of the arc surface and a horizontal direction are different, where all the tangents except one are not parallel to the horizontal direction. In this way, more high-angle rays propagated in the first pixel definition layer are emitted in a non-horizontal direction and used for display.

In some possible implementations, sub-pixel regions of different colors have different light-emitting efficiency. For example, the sub-pixel region includes a red sub-pixel region, a green sub-pixel region, and a blue sub-pixel region, and light-emitting efficiency of the blue sub-pixel region is less than light-emitting efficiency of the red sub-pixel region and light-emitting efficiency of the green sub-pixel region. Therefore, in this application, a taper angle of the first protrusion close to the blue sub-pixel region may be further increased, so that after being reflected by the anode, the ray is emitted from the display panel at a small angle and used for display. This can improve brightness of blue light viewed from a front-view angle.

Further, a person skilled in the art should know that a larger taper angle of the second protrusion indicates greater brightness attenuation of the sub-pixel region close to the second protrusion. In other words, when the display panel is viewed from the front, the viewed display brightness is high. However, when the display panel is viewed from a side, brightness of a high-angle ray emitted from the display panel is greatly reduced, affecting user experience.

In view of this, in this application, further, an area of the blue sub-pixel region may be greater than an area of the red sub-pixel region and an area of the green sub-pixel region. In this way, brightness of blue light can be improved. In addition, because the area of the blue sub-pixel region is large, a high-angle ray emitted from the middle part of the blue sub-pixel region may be directly emitted at a large angle and used for display, and is not emitted to the first pixel definition layer. Therefore, all rays emitted from the middle part of the blue sub-pixel region are not affected by the taper angle of the second protrusion, and brightness of the ray emitted from the middle part of the blue sub-pixel region is not attenuated.

According to a second aspect, this application provides a display panel. The display panel includes an encapsulation layer and the array base plane according to the first aspect. The array base plane further includes a light-emitting layer and a cathode that are disposed on a substrate, a first pixel definition layer is disposed between adjacent light-emitting layers, and the cathode is disposed between the first pixel definition layer and the encapsulation layer. In a direction from the substrate to the first pixel definition layer, the encapsulation layer includes a first inorganic encapsulation layer and an organic encapsulation layer that are sequentially stacked, where a refractive index of the first inorganic encapsulation layer is greater than a refractive index of the organic encapsulation layer, and patterns of parts that are of the cathode and the first inorganic encapsulation layer and that overlap a first protrusion correspond to a pattern of the first protrusion.

The cathode and the first inorganic encapsulation layer may be disposed on a side that is of the first pixel definition layer and that is away from the substrate, and thicknesses of the cathode and the first inorganic encapsulation layer are usually small. Therefore, the patterns of the parts that are of the cathode and the first inorganic encapsulation layer and that overlap the first protrusion correspond to the pattern of the first protrusion, and the part that is of the first inorganic encapsulation layer and that overlaps the first protrusion may also include a plurality of protrusions. In one aspect, surfaces that are of the cathode and the first inorganic encapsulation layer and that are away from the substrate in this application are more uneven than those of a cathode and a first inorganic encapsulation layer in a related technology. In this case, after a ray is incident to the cathode and the first inorganic encapsulation layer, and then is propagated in a waveguide mode through the cathode and the first inorganic encapsulation layer, the ray is likely to be emitted from the uneven cathode and the uneven first inorganic encapsulation layer, so that more rays are used for display. In another aspect, after the ray is incident to the first inorganic encapsulation layer, the ray is no longer incident from the first inorganic encapsulation layer to the organic encapsulation layer at a single angle, but is incident to the organic encapsulation layer at different angles based on a shape of a protrusion in the first encapsulation layer, so that total reflection that occurs when the ray is incident from the first inorganic encapsulation layer to the organic encapsulation layer can be improved, and more rays incident from the first inorganic encapsulation layer to the organic encapsulation layer are free from total reflection. This improves display brightness of the display panel without increasing power consumption of the display panel.

In some possible implementations, the refractive index of the first inorganic encapsulation layer may range from 1.75 to 1.85, and the refractive index of the organic encapsulation layer may range from 1.48 to 1.5.

In some possible implementations, the encapsulation layer further includes a second inorganic encapsulation layer. The first inorganic encapsulation layer, the organic encapsulation layer, and the second inorganic encapsulation layer are sequentially stacked in a direction from the substrate to a light-emitting device. Materials of the first inorganic encapsulation layer and the second inorganic encapsulation layer include an inorganic insulation material, and the inorganic insulation material may be used to block water vapor and oxygen. A material of the organic encapsulation layer includes an organic insulation material. In a case in which total thicknesses of encapsulation layers are the same, compared with a solution in which the encapsulation layer includes only an inorganic insulation material, a solution of using the organic insulation material can improve flexibility of the display panel.

According to a third aspect, this application provides a terminal device. The terminal device includes a frame body, a cover plate, and the display panel according to the second aspect. The display panel is disposed in space enclosed by the frame body and the cover plate.

The third aspect and any implementation of the third aspect respectively correspond to the first aspect and any implementation of the first aspect or the second aspect and any implementation of the second aspect. For technical effects corresponding to the first aspect, the second aspect, any implementation of the first aspect, and any implementation of the second aspect, refer to technical effects corresponding to the first aspect and any implementation of the first aspect. Details are not described herein again.

According to a fourth aspect, this application provides a method for preparing an array base plane, where the array base plane has a plurality of sub-pixel regions. The method for preparing an array base plane includes: forming a first pixel definition layer on a substrate, where the first pixel definition layer is disposed between adjacent sub-pixel regions, and the first pixel definition layer includes a plurality of first protrusions in a direction from any one of the sub-pixel regions to a sub-pixel region adjacent to the any one sub-pixel region.

In this application, the first pixel definition layer between the adjacent sub-pixel regions includes the plurality of first protrusions, and the plurality of first protrusions are arranged in the direction from the any one of the sub-pixel regions to the sub-pixel region adjacent to the any one sub-pixel region. Therefore, a surface that is of the first pixel definition layer including the plurality of first protrusions and that is away from the substrate in this application is more uneven than that of a pixel definition layer in a related technology. In this way, when the array base plane is used in a display panel, and a high-angle ray emitted from the any one sub-pixel region is propagated in a waveguide mode through a surface that is of the first pixel definition layer and that is away from the substrate, the ray is more likely to be emitted from the more uneven first pixel definition layer, so that more high-angle rays are emitted from the first pixel definition layer and used for display. This can resolve a problem in a related technology that a high-angle ray propagated in a waveguide mode in a direction parallel to a horizontal plane in the pixel definition layer always cannot be emitted. This improves display brightness of the display panel without increasing power consumption of the display panel.

In some possible implementations, before forming the first pixel definition layer, the method for preparing an array base plane further includes: sequentially forming a planarization layer and an anode on the substrate. The planarization layer includes a second protrusion, the second protrusion is disposed between adjacent anodes, a taper angle of the second protrusion is a non-right angle, and a side surface of the second protrusion gradually tilts from the anode to the planarization layer in a direction from the substrate to the planarization layer. The anode is located in the sub-pixel region, and the anode extends from the sub-pixel region and the side surface of the second protrusion to a side that is of the second protrusion and that is away from the substrate.

In this way, a side surface of the anode may be used as a reflective surface, and some high-angle rays projected onto the side surface of the anode may be reflected by the side surface of the anode to the display panel and used for display, to improve display brightness of the display panel.

In some possible implementations, when forming the first pixel definition layer on the substrate, the method for preparing an array base plane further includes: forming a second pixel definition layer, where the second pixel definition layer includes a third protrusion, the third protrusion is disposed between adjacent first protrusions, a width of the first protrusion is less than a width of the third protrusion in the direction from the any one of the sub-pixel regions to the sub-pixel region adjacent to the any one sub-pixel region, and a thickness of the first protrusion is less than a thickness of the third protrusion in a direction from the substrate to the first pixel definition layer.

In this way, the first protrusion has a small width and a small thickness, so that a distance between a light-emitting layer and the side surface of the anode can be reduced, to avoid a case in which because the distance between the light-emitting layer and the side surface of the anode is excessively large, some rays cannot be reflected by the side surface of the anode and used for display.

In some possible implementations, the first pixel definition layer and the second pixel definition layer each include a photosensitive material. For example, a material of the first pixel definition layer and a material of the second pixel definition layer are the same as a material of a positive photoresist. Patterns of the first pixel definition layer and the second pixel definition layer may be obtained by using film formation, exposure, and development in a same semiconductor process. In this way, the first pixel definition layer and the second pixel definition layer that have different patterns may be prepared by using a same mask, and an etching process may be omitted.

Specifically, after a pixel definition thin film is formed, the pixel definition thin film is exposed. During exposure, an opening of a mask corresponds to a part of the pixel definition thin film except a to-be-formed first protrusion and a to-be-formed third protrusion. In addition, because the width of the third protrusion is greater than the width of the first protrusion, when the pixel definition thin film is exposed, impact on the to-be-formed first protrusion is greater than impact on the to-be-formed third protrusion, and the thickness of the first protrusion obtained after development is also less than the thickness of the third protrusion. That is, the first pixel definition layer and the second pixel definition layer can be obtained by exposing the pixel definition thin film by using only one mask.

### BRIEF DESCRIPTION OF DRAWINGS

FIG. 1a is a diagram of a structure of a terminal device according to an embodiment of this application;
FIG. 1b is a distribution diagram of a display region and a non-display region in a mobile phone according to an embodiment of this application;
FIG. 1c is an arrangement diagram of sub-pixel regions in a display region according to an embodiment of this application;
FIG. 2 is a diagram of a structure of a display panel according to an embodiment of this application;
FIG. 3 is a diagram of a structure of a display panel according to a related technology;
FIG. 4a is a top view of an array base plane according to an embodiment of this application;
FIG. 4b is a diagram of a structure of a display panel according to an embodiment of this application;
FIG. 4c is a diagram of a structure of another display panel according to an embodiment of this application;
FIG. 4d is a diagram of a structure of still another display panel according to an embodiment of this application;
FIG. 4e is a diagram of a structure of still another display panel according to an embodiment of this application;
FIG. 5 is a diagram of a structure of still another display panel according to an embodiment of this application;
FIG. 6a is a diagram of a structure of still another display panel according to an embodiment of this application;
FIG. 6b is a diagram of a structure of still another display panel according to an embodiment of this application;
FIG. 7a is a diagram of a structure of still another display panel according to an embodiment of this application;
FIG. 7b is a diagram of a structure of still another display panel according to an embodiment of this application;
FIG. 7c is a diagram of a structure of still another display panel according to an embodiment of this application;
FIG. 7d is a diagram of a structure of still another display panel according to an embodiment of this application;
FIG. 8 is a diagram of a structure of still another display panel according to an embodiment of this application;
FIG. 9a is a top view of another array base plane according to an embodiment of this application;
FIG. 9b is a diagram of a structure of still another display panel according to an embodiment of this application;
FIG. 9c is a diagram of a structure of still another display panel according to an embodiment of this application;
FIG. 10a is a diagram depicting a process for preparing a planarization layer according to an embodiment of this application;
FIG. 10b is a diagram depicting a process for preparing a planarization layer according to an embodiment of this application;
FIG. 10c is a diagram depicting a process for preparing a planarization layer according to an embodiment of this application;
FIG. 10d is a diagram depicting a process for preparing a planarization layer according to an embodiment of this application;
FIG. 10e is a diagram depicting a process for preparing a planarization layer according to an embodiment of this application;
FIG. 10f is a diagram depicting a process for preparing a planarization layer according to an embodiment of this application;
FIG. 11 is a diagram of a structure of an array base plane according to an embodiment of this application; and
FIG. 12 is a diagram of a structure of still another display panel according to an embodiment of this application.

### Reference numerals:

1: frame; 2: cover plate; 3: display panel; 31: array base plane; 311: thin film transistor; 312: light-emitting device; 3121: anode; 3122: light-emitting layer; 3123: cathode; 313: planarization layer; 3131: planarization thin film; 3132: planarization pattern; 3141: first pixel definition layer; 3142: second pixel definition layer; 32: encapsulation layer; 321: first inorganic encapsulation layer; 322: organic encapsulation layer; 323: second inorganic encapsulation layer; 4: circuit board; 50: photoresist; 51: first photoresist pattern; 52: second photoresist pattern; 10: substrate; 101: display region; 1011: sub-pixel region; 102: non-display region.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

The terms "first", "second", and the like in the specification and claims in embodiments of this application are intended to distinguish between different objects, but are not intended to describe a particular order of the objects. For example, a first target object, a second target object, and the like are used for distinguishing between different target objects, but are not used for describing a specific order of the target objects.

In embodiments of this application, the word like "exemplary" or "for example" is used to represent giving an example, an illustration, or a description. Any embodiment or design scheme described as an "example" or "for example" in embodiments of this application should not be explained as being more preferred or having more advantages than another embodiment or design scheme. To be precise, use of the word like "example" or "for example" is intended to present a relative concept in a specific manner.

In descriptions of embodiments of this application, unless otherwise stated, "plurality of" means two or more. For example, a plurality of processing units mean two or more processing units, and a plurality of systems mean two or more systems.

An embodiment of this application provides a terminal device. The terminal device may be an electronic device having a display function, for example, a mobile phone, a computer, a tablet computer, a personal digital assistant (personal digital assistant, PDA), an in-vehicle computer, a television, or a smartwatch. A specific form of the terminal device is not specially limited in embodiments of this application.

The terminal device may be an OLED display, a quantum dot light-emitting diode (quantum dot light-emitting diode, QLED) display, or the like. The OLED display and the quantum dot light-emitting diode display apparatus may implement display through top light emission or bottom light emission. This is not specifically limited in embodiments of this application. For ease of description, unless otherwise specified, in the following descriptions, the OLED display and the QLED display implement display through top light emission.

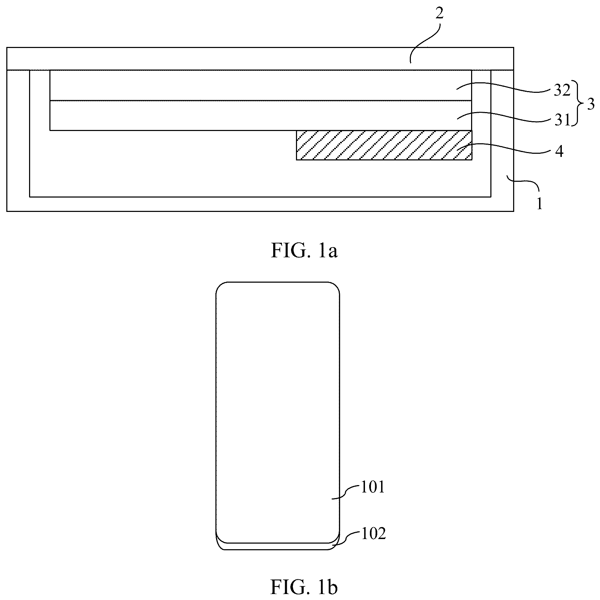

In an example, as shown in FIG. 1a, a display apparatus is an OLED display. The OLED display may include a frame 1, a cover plate 2, a display panel 3, a circuit board 4, and other electronic accessories including a camera and the like. The display panel 3, the circuit board 4, and the other electronic accessories are disposed in an accommodating cavity formed by the frame 1 and the cover plate 2. The cover plate 2 is disposed on a light-emitting side of the display panel 3. The circuit board 4 is disposed on a side that is of the display panel 3 and that is away from the cover plate 2.

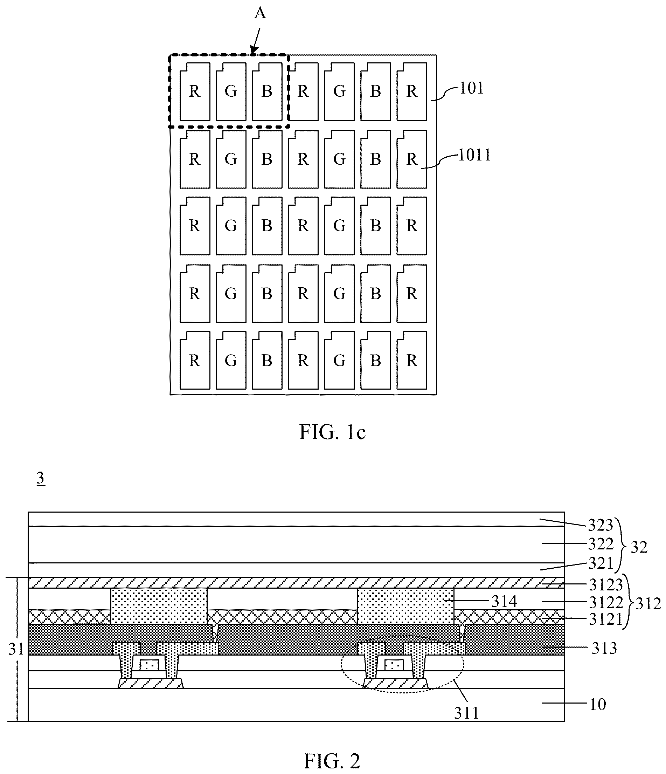

As shown in FIG. 1b and FIG. 1c, the display panel 3 includes a display region 101, and the display region 101 includes a multi-sub-pixel region A. The pixel region A includes a plurality of sub-pixel regions 1011, and light emitted from the plurality of sub-pixel regions 1011 in the pixel region A includes three primary colors. For example, the plurality of sub-pixel regions 1011 in the pixel region A may include a red sub-pixel region, a green sub-pixel region, and a blue sub-pixel region; or the plurality of sub-pixel regions 1011 in the pixel region A may include a cyan sub-pixel region, a yellow sub-pixel region, and a magenta sub-pixel region. On this basis, as shown in FIG. 1c, the display region 101 further includes a non-sub-pixel region located between sub-pixel regions.

In some embodiments, as shown in FIG. 1b, the display apparatus further has a non-display region 102 located on a periphery of the display region 101, and the non-display region 102 is located on at least one side of the display region 101. For example, for a full-screen mobile phone, the non-display region 102 is located only on one side of the display region 101, and structures such as a cable and a circuit may be disposed in the non-display region 102. For example, a gate driver on array (gate driver on array, GOA for short) circuit may be disposed in the non-display region 102 to replace a gate chip.

As shown in FIG. 2, the display panel 3 may include an array base plane 31 and an encapsulation layer 32. In the display region 101, the array base plane 31 includes a substrate 10, and a thin film transistor (thin film transistor, TFT) 311, a planarization layer 313, and a plurality of light-emitting devices 312 that are sequentially stacked on the substrate 10. The thin film transistor 311 includes an active layer, a source, a drain, a gate insulation layer, and a gate. The light-emitting device 312 includes an anode 3121, a light-emitting layer 3122, and a cathode 3123 that are sequentially stacked on the substrate 10. The anode 3121 is electrically connected to the drain through a via in the planarization layer 313. Voltage is separately applied to the anode 3121 and the cathode 3123, so that electron holes may be injected from the anode 3121, electrons may be injected from the cathode 3123, and the electrons and the electron holes meet at the light-emitting layer 3122 to form excitons, to excite the light-emitting layer 3122 to emit light. In addition, display brightness of the OLED display may be further adjusted by adjusting the voltage input to the anode 3121.

The array base plane 31 further includes a pixel definition layer 314 disposed on the substrate 10, and the pixel definition layer 314 is disposed between adjacent sub-pixel regions 1011, to prevent crosstalk of display light of different colors emitted from the adjacent sub-pixel regions 1011.

A material of the active layer of the thin film transistor 311 includes but is not limited to low temperature poly-silicon (low temperature poly-silicon, LTPS), oxide, low temperature polycrystalline oxide (low temperature polycrystalline oxide, LTPO), amorphous silicon (a-Si), organic matter, or the like.

A material of the planarization layer 313 includes but is not limited to an organic polymer such as polyimide, siloxane, polyamide, or acrylic acid.

A material of the pixel definition layer 314 includes but is not limited to an organic polymer such as polyimide, siloxane, polyamide, or acrylic acid.

A material of the anode 3121 includes but is not limited to metal such as silver, aluminum, indium tin oxide, or metal oxide, or alloy.

As shown in FIG. 2, the encapsulation layer 32 is used to encapsulate the light-emitting device 312, to prevent water vapor and oxygen from entering the light-emitting layer 3122, so that life of use of the light-emitting layer 3122 is not affected. If the OLED display is a flexible display apparatus, for example, if the OLED display is a curved mobile phone or a foldable mobile phone, the encapsulation layer 32 may include, in a direction from a first electrode 3121 to a second electrode 3123, a first inorganic encapsulation layer 321, an organic encapsulation layer 322, and a second inorganic encapsulation layer 323 that are sequentially stacked. Materials of the first inorganic encapsulation layer 321 and the second inorganic encapsulation layer 323 include an inorganic insulation material, and the inorganic insulation material may be used to block water vapor and oxygen. A material of the organic encapsulation layer 322 includes an organic insulation material. In a case in which total thicknesses of encapsulation layers 32 are the same, compared with a solution in which the encapsulation layer 32 includes only an inorganic insulation material, a solution of using the organic insulation material can improve flexibility of the OLED display.

As mentioned in the background, limited by various factors, the display is to be improved in display brightness. For example, the inventor finds that the following two problems limit the display brightness of the display.

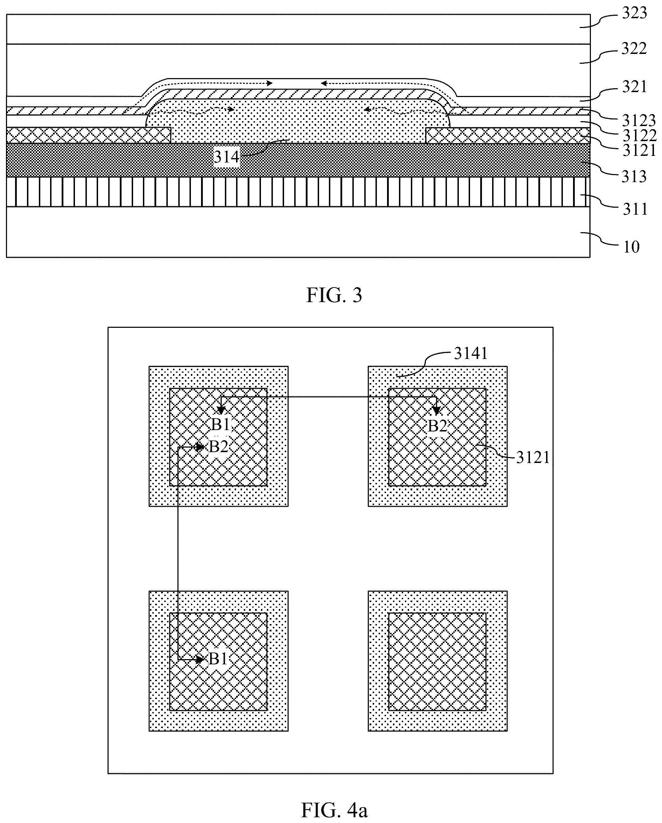

First problem: As shown in FIG. 3, after high-angle rays (dashed arrows in FIG. 3) emitted from the light-emitting layer 3122 are incident to the pixel definition layer 314, the cathode 3123, and the encapsulation layer 32, the rays are propagated along the pixel definition layer 314, the cathode 3123, and the encapsulation layer 32 in a waveguide mode. As a result, the high-angle rays are propagated horizontally in the pixel definition layer 314, the cathode 3123, and the encapsulation layer 32 along the pixel definition layer 314, the cathode 3123, and a surface that is of the encapsulation layer 32 and that is away from the substrate, and cannot be emitted from the pixel definition layer 314 and used for display. In this application, a horizontal direction may be parallel to a surface that is of the substrate 10 and that faces the light-emitting device 312. The horizontal direction varies with a placement position of the array base plane 31.

Herein, a person skilled in the art should know that, the high-angle rays emitted from the light-emitting layer 3122 mean that, in an example in which an angle of a ray emitted perpendicularly to a surface that is of the substrate 10 and that faces the light-emitting device 312 is 0°, a larger angle between a ray and the ray emitted at 0° indicates a larger angle of the ray. For example, it may be specified that a ray whose included angle with the ray emitted at 0° is greater than 85° is a high-angle ray. Certainly, a limited range of the high-angle ray may be alternatively another parameter value. This is not limited in embodiments of this application.

In a second problem, as shown in FIG. 3, in a case in which the encapsulation layer 32 includes the first inorganic encapsulation layer 321 and the organic encapsulation layer 322, and the first inorganic encapsulation layer 321 and the organic encapsulation layer 322 are sequentially stacked in the direction from the first electrode 3121 to the second electrode 3123, because a refractive index of an inorganic material is usually greater than that of an organic material, total reflection is likely to occur when some rays (dashed arrows in FIG. 3) are incident from the first inorganic encapsulation layer 321 to the organic encapsulation layer 322. In other words, a ray from the first inorganic encapsulation layer 321 cannot be incident to the organic encapsulation layer 322 and used for display.

In view of this, in embodiments of this application, the pixel definition layer 314 is improved, to improve display brightness of a display without increasing power consumption of the display.

As shown in FIG. 4a to FIG. 4e, an embodiment of this application provides an array base plane 31. The array base plane 31 may include a substrate 10 and a first pixel definition layer 3141 disposed on the substrate 10. The first pixel definition layer is disposed between adjacent sub-pixel regions 1011, and the first pixel definition layer 3141 includes a plurality of first protrusions in a direction from any one of the sub-pixel regions 1011 to a sub-pixel region 1011 adjacent to the any one sub-pixel region 1011.

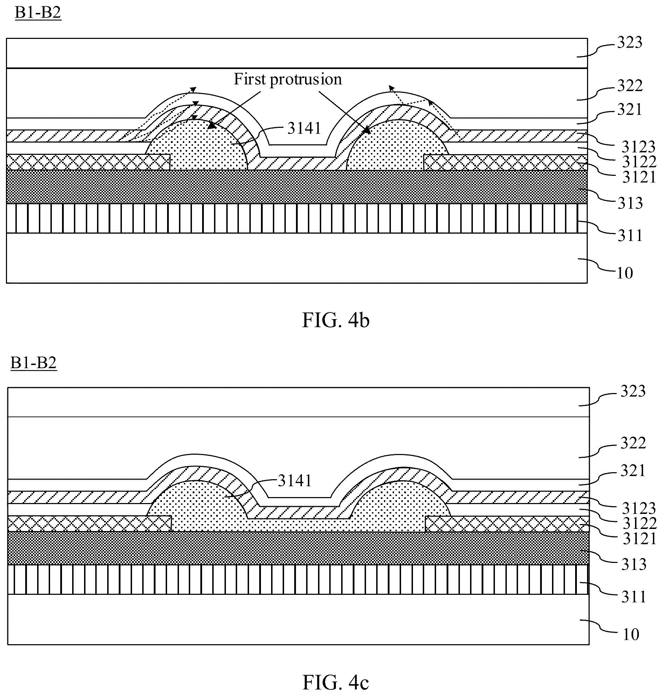

In this application, the first pixel definition layer 3141 between the adjacent sub-pixel regions 1011 includes the plurality of first protrusions, and the plurality of first protrusions are arranged in the direction from the any one of the sub-pixel regions 1011 to the sub-pixel region 1011 adjacent to the any one sub-pixel region 1011. Therefore, a surface that is of the first pixel definition layer 3141 including the plurality of first protrusions and that is away from the substrate 10 in this application is more uneven than that of a pixel definition layer 314 in a related technology. In this way, when the array base plane 31 is used in a display panel 3, and a high-angle ray emitted from the any one sub-pixel region 1011 is propagated in a waveguide mode through the surface that is of the first pixel definition layer 3141 and that is away from the substrate 10 (where an optical path is indicated by dashed arrows in FIG. 4b), the ray is more likely to be emitted from the more uneven first pixel definition layer 3141, so that more high-angle rays are emitted from the first pixel definition layer 3141 and used for display. This can resolve a problem in a related technology that a high-angle ray propagated in a waveguide mode in a direction parallel to a horizontal plane in the pixel definition layer 314 always cannot be emitted. This improves display brightness of the display panel 3 without increasing power consumption of the display panel 3.

In some possible implementations, as shown in FIG. 4a to FIG. 4e, adjacent first protrusions are spaced apart; and in a direction from the substrate 10 to the pixel definition layer 314, a thickness of a part that is of the first pixel definition layer 3141 and that is located between the adjacent first protrusions is less than a thickness of a part of the first protrusion.

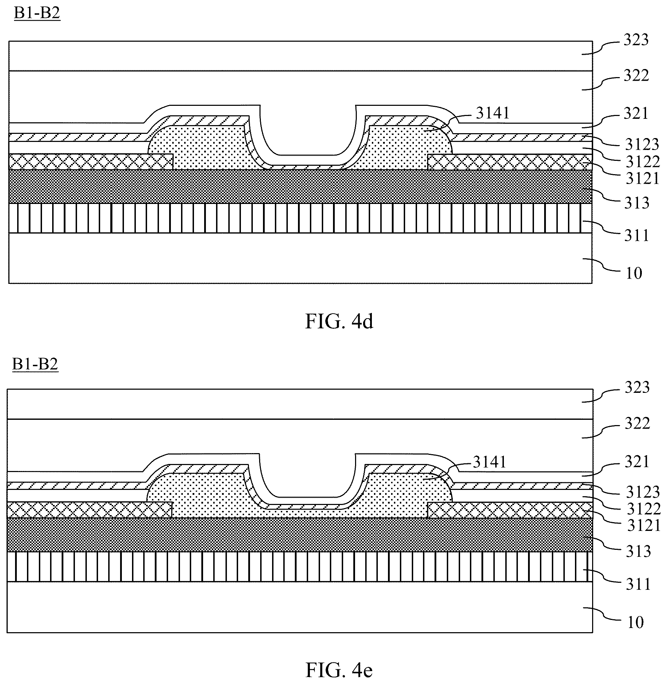

For example, as shown in FIG. 4b and FIG. 4d, in a direction from the substrate 10 to the first pixel definition layer 3141, the thickness of the part that is of the first pixel definition layer 3141 and that is located between the adjacent first protrusions is 0, and a thickness of a part of the first protrusion in the first pixel definition layer 3141 is greater than 0.

For another example, as shown in FIG. 4c and FIG. 4e, a thickness of a part that is of the first pixel definition layer 3141 and that is located between the first protrusions is greater than 0, and the thickness of the part that is of the first pixel definition layer 3141 and that is located between the first protrusions is less than the thickness of the part that is of the first protrusion.

As shown in FIG. 4c, in a case in which the thickness of the part that is of the first pixel definition layer 3141 and that is located between the first protrusions is greater than 0, a surface, of the part that is of the first pixel definition layer 3141 and that is located between the first protrusions, away from the substrate may be, for example, parallel to the horizontal plane. Certainly, the surface, of the part that is of the first pixel definition layer 3141 and that is located between the first protrusions, away from the substrate may be alternatively in another shape, provided that the thickness of the part that is of the first pixel definition layer 3141 and that is located between the first protrusions is less than the thickness of the part of the first protrusion in the first pixel definition layer 3141. This is not limited in this embodiment of this application.

In some possible implementations, a shape of the first protrusion is not limited in embodiments of this application, and shapes of the plurality of first protrusions may be the same or may be different. In the direction from the substrate 10 to the first pixel definition layer 3141, thicknesses of the plurality of first protrusions may be the same or may be different. In the direction from the any one of the sub-pixel regions 1011 to the sub-pixel region 1011 adjacent to the any one sub-pixel region 1011, widths of the plurality of first protrusions may be the same or may be different.

For example, as shown in FIG. 4b, the first protrusion is in a shape of a curved surface. For example, the first protrusion may be in a shape of an arc surface; or the first protrusion is a prism without a bottom surface. Certainly, the plurality of first protrusions may be alternatively in another shape. This is not limited in embodiments of this application.

Optionally, the plurality of first protrusions may be in a shape of a curved surface. Different from another shape, in the direction from the any one of the sub-pixel regions 1011 to the sub-pixel region 1011 adjacent to the any one sub-pixel region 1011, included angles between countless tangents at all positions of the arc surface and a horizontal direction are different, where all the tangents except one are not parallel to the horizontal direction. In this way, more high-angle rays propagated in the first pixel definition layer 3141 in a waveguide mode are emitted from the first pixel definition layer 3141 and used for display.

In some possible implementations, a shape of the part that is of the first pixel definition layer 3141 and that is located between the first protrusions is not limited in embodiments of this application. The shape of the part that is of the first pixel definition layer 3141 and that is located between the first protrusions may be determined based on a side wall of the first protrusion and the thickness of the part that is of the first pixel definition layer 3141 and that is located between the first protrusions. For example, as shown in FIG. 4b to FIG. 4e, the part that is of the first pixel definition layer 3141 and that is located between the first protrusions may be pits of different shapes.

Optionally, the pit may be in a shape of a curved surface. For example, the pit may be in a shape of an arc surface. Different from another shape, in the direction from the any one of the sub-pixel regions 1011 to the sub-pixel region 1011 adjacent to the any one sub-pixel region 1011, included angles between countless tangents at all positions of the arc surface and a horizontal direction are different, where all the tangents except one are not parallel to the horizontal direction. In this way, more high-angle rays propagated in the first pixel definition layer 3141 in a waveguide mode are emitted from the first pixel definition layer 3141 and used for display.

In some possible implementations, a plurality of sub-pixel regions 1011 may be arranged in any manner, and an array arrangement manner shown in FIG. 1c is merely an example. Regardless of an arrangement manner, a first pixel definition layer 3141 between two adjacent sub-pixel regions 1011 includes a plurality of first protrusions, and the plurality of first protrusions are arranged in the direction from the any one of the sub-pixel regions 1011 to the sub-pixel region 1011 adjacent to the any one sub-pixel region 1011.

In some possible implementations, a person skilled in the art should know that, in the display panel 3, one complete light-emitting area that emits light of one color may be considered as one sub-pixel region 1011. As mentioned above, the light-emitting layer 3122 in the light-emitting device 312 is a light-emitting structure of the display panel 3. In view of this, in a case in which positions of the light-emitting layer 3122 emit light, the light-emitting layer 3122 of each light-emitting device 312 may be considered as one sub-pixel region 1011.

Further, as mentioned above, the first pixel definition layer 3141 is disposed between adjacent sub-pixel regions 1011. In other words, any one first pixel definition layer 3141 is disposed between adjacent light-emitting layers 3122. A position relationship between the any one first pixel definition layer 3141 and two light-emitting layers 3122 adjacent to the any one first pixel definition layer 3141 may include the following two cases:

In a first case, as shown in FIG. 4b to FIG. 4e, the first pixel definition layer 3141 may be in contact with a light-emitting layer 3122 adjacent to the first pixel definition layer 3141, and an orthographic projection of the first pixel definition layer 3141 on the substrate 10 does not overlap an orthographic projection of the light-emitting layer 3122 adjacent to the first pixel definition layer 3141 on the substrate 10. Herein, overlapping between orthographic projections of the first protrusion and the first pixel definition layer 3141 on the substrate 10 due to a slope of the first protrusion and a thickness of the first pixel definition layer 3141 may be ignored.

The orthographic projection of the first pixel definition layer 3141 on the substrate 10 is a projection of the first pixel definition layer 3141 vertically projected onto the substrate 10. The orthographic projection of the light-emitting layer 3122 on the substrate 10 is a projection of the light-emitting layer 3122 vertically projected onto the substrate 10. For orthographic projections of other structures on the substrate 10 mentioned below, refer to this explanation. Details are not described below again.

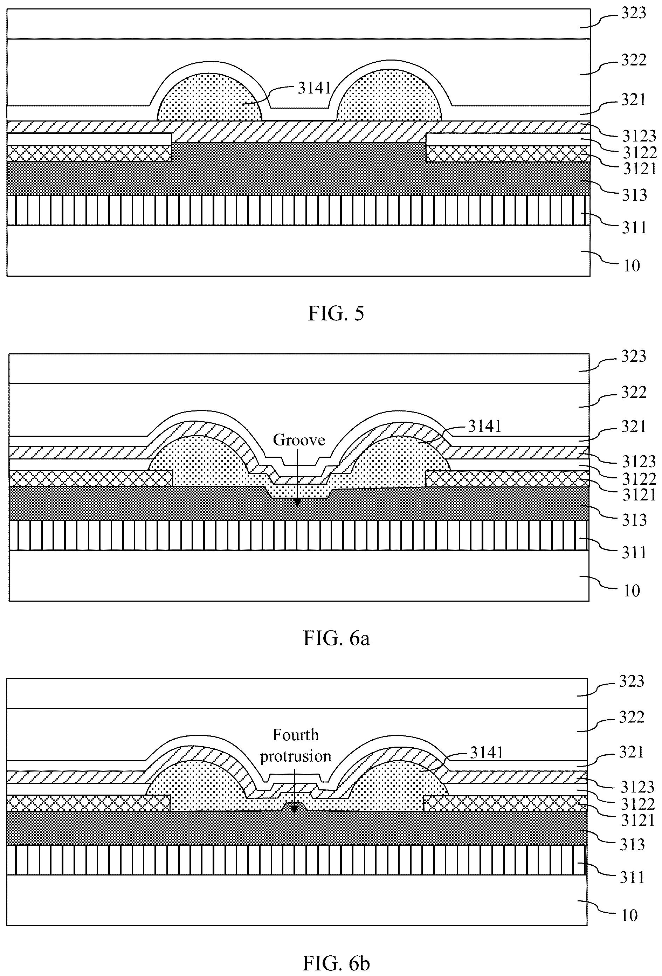

In a second case, as shown in FIG. 5, the first pixel definition layer 3141 is in contact with a light-emitting layer 3122 adjacent to the first pixel definition layer 3141, and an overlapping region exists between an orthographic projection of the first pixel definition layer 3141 on the substrate 10 and an orthographic projection of the light-emitting layer 3122 adjacent to the first pixel definition layer 3141 on the substrate 10.

In the second case, to avoid a case in which because a part that is of the first pixel definition layer 3141 and that overlaps the light-emitting layer 3122 is disposed between an anode 3121 and the light-emitting layer 3122 or disposed between a cathode 3123 and the light-emitting layer 3122, the anode 3121 and the cathode 3123 cannot simultaneously inject electrons and electron holes into a part that is of the light-emitting layer 3122 and that overlaps the first pixel definition layer 3141, and consequently, the part that is of the light-emitting layer 3122 and that overlaps the first pixel definition layer 3141 cannot emit light, optionally, the first pixel definition layer 3141 may be disposed on a side that is of the cathode 3123 and that is away from the substrate 10, to ensure that light can be emitted at various positions of the light-emitting layer 3122.

In addition, because a material of the first pixel definition layer 3141 is a light-transmitting material, even if the first pixel definition layer 3141 is disposed on the side that is of the cathode 3123 and that is away from the substrate 10, and the overlapping region exists between the orthographic projection of the first pixel definition layer 3141 on the substrate 10 and the orthographic projection of the light-emitting layer 3122 adjacent to the first pixel definition layer 3141 on the substrate 10, the first pixel definition layer 3141 does not completely block a ray emitted from the light-emitting layer 3122.

In some possible implementations, a quantity of first protrusions between a plurality of groups of adjacent light-emitting layers 3122 and/or a quantity of grooves between a plurality of groups of adjacent light-emitting layers 3122 are/is not limited in embodiments of this application, and the quantity of first protrusions between a plurality of groups of adjacent light-emitting layers 3122 may be the same or may be different and/or the quantity of grooves between a plurality of groups of adjacent light-emitting layers 3122 may be the same or may be different. For example, two first protrusions are included between a red sub-pixel region and a blue sub-pixel region, and three first protrusions are included between the red sub-pixel region and a green sub-pixel region.

In some embodiments, as shown in FIG. 6a and FIG. 6b, the array base plane 31 further includes a planarization layer 313, and the planarization layer 313 is disposed between the substrate 10 and the pixel definition layer 314. In a case in which the thickness of the part that is of the first pixel definition layer 3141 and that is located between the adjacent first protrusions is greater than 0, the planarization layer 313 includes a fourth protrusion and/or a groove, and an orthographic projection of the fourth protrusion and/or an orthographic projection of the groove on the substrate 10 are/is located between orthographic projections of the adjacent first protrusions on the substrate 10.

Because the first pixel definition layer 3141 is disposed on a side that is of the planarization layer 313 and that is away from the substrate 10, in a case in which the planarization layer 313 includes the fourth protrusion and/or the groove, a pattern of the first pixel definition layer 3141 disposed on the side that is of the planarization layer 313 and that is away from the substrate 10 corresponds to the fourth protrusion and/or the groove of the planarization layer 313, and also includes the fourth protrusion and/or the groove. In addition, the orthographic projection of the fourth protrusion and/or the orthographic projection of the groove on the substrate 10 are/is located between the orthographic projections of the adjacent first protrusions on the substrate 10. In this way, if some high-angle rays passing through the first protrusion are still not emitted from the first pixel definition layer 3141 and used for display, the some high-angle rays may further propagate along the fourth protrusion and/or the groove of the first pixel definition layer 3141, break a horizontal propagation angle again by using the fourth protrusion and/or the groove, and are emitted from the display panel 3 and used for display, to further improve display brightness of the display panel 3.

In some possible implementations, a shape of the fourth protrusion and/or a shape of the groove are/is not limited in embodiments of this application. For example, the fourth protrusion and/or the groove are/is in a shape of a curved surface, or the fourth protrusion and/or the groove are/is in a shape of a prism without a bottom surface. Certainly, the fourth protrusion and/or the groove may be alternatively in another shape. This is not limited in embodiments of this application.

Optionally, the fourth protrusion and/or the groove may be in a shape of a curved surface. For example, the fourth protrusion and/or the groove may be in a shape of an arc surface. Different from another shape, in the direction from the any one of the sub-pixel regions 1011 to the sub-pixel region 1011 adjacent to the any one sub-pixel region 1011, included angles between countless tangents at all positions of the arc surface and a horizontal direction are different, where all the tangents except one are not parallel to the horizontal direction. In this way, more high-angle rays propagated in the first pixel definition layer 3141 are emitted in a non-horizontal direction and used for display.

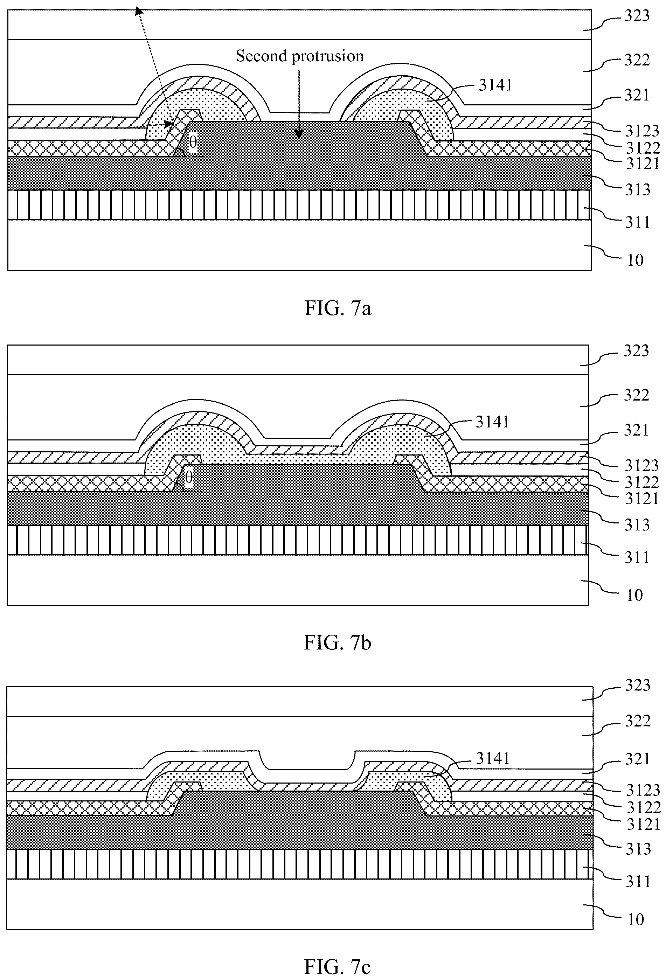

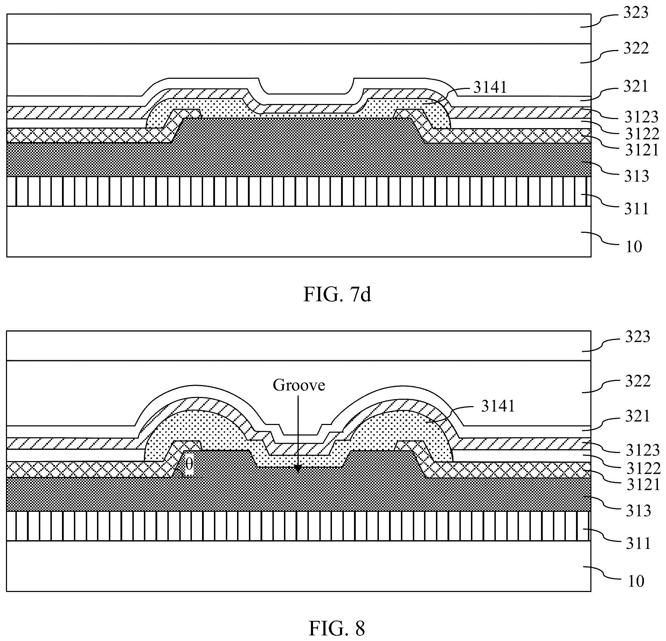

In some embodiments, as shown in FIG. 7a to FIG. 7d, the array base plane 31 includes an anode 3121 in addition to the planarization layer 313, and the anode 3121 is disposed between adjacent sub-pixel regions 1011. The planarization layer 313 includes a second protrusion, the second protrusion is disposed between adjacent anodes 3121, a taper angle θ of the second protrusion is a non-right angle, and a side surface of the second protrusion gradually tilts from the anode 3121 to the planarization layer 313 in a direction from the substrate 10 to the planarization layer 313. In addition, the anode 3121 extends from the sub-pixel region 1011 and the side surface of the second protrusion to a side that is of the second protrusion and that is away from the substrate 10.

Herein, the side surface of the second protrusion is a surface between a surface that is of the second protrusion and that faces the substrate 10 and a surface that is of the second protrusion and that is away from the substrate 10. A side surface of the anode 3121 below is a surface that is of the anode 3121 and that is disposed on the side surface of the second protrusion.

Because the anode 3121 extends from the sub-pixel region 1011 and the side surface of the second protrusion to the side that is of the second protrusion and that is away from the substrate 10, a tilt angle of a part that is of the anode 3121 and that corresponds to the side surface of the second protrusion is the same as the taper angle θ of the second protrusion, and is also a non-right angle, and the side surface of the anode 3121 gradually tilts from the anode 3121 to the planarization layer 313 in the direction from the substrate 10 to the planarization layer 313.

Herein, the taper angle of the second protrusion is an included angle between the second protrusion and the horizontal direction.

In some possible implementations, the taper angle θ of the second protrusion is not limited in embodiments of this application, provided that the taper angle θ of the second protrusion is a non-right angle. In this way, some high-angle rays projected onto the side surface of the anode 3121 may be further reflected by the anode 3121 to the display panel 3 and used for display, to improve display brightness of the display panel 3.

For example, the taper angle θ of the second protrusion may range from 5° to 85°. For example, the taper angle θ of the second protrusion may be 5°, 20°, 45°, 60°, or 85°.

Optionally, the taper angle of the second protrusion may range from 20° to 60°, to avoid a case in which a film layer (for example, a cathode) disposed on a side that is of the first pixel definition layer 3141 and that is away from the substrate 10 is broken because the taper angle θ of the second protrusion is excessively large.

In some possible implementations, the side surface of the second protrusion is in a shape of a sawtooth. In this way, a side surface that is of the anode 3121 and that corresponds to the side surface of the second protrusion is also in a shape of a sawtooth, so that efficiency of reflecting a high-angle ray by the anode 3121 can be further improved, to improve display brightness of the display panel 3.

As shown in FIG. 8, in a case in which the planarization layer 313 includes the second protrusion, and the anode 3121 extends from the sub-pixel region 1011 and the side surface of the second protrusion to the side that is of the second protrusion and that is away from the substrate 10, if the thickness of the part that is of the first pixel definition layer 3141 and that is located between the adjacent first protrusions is greater than 0, the planarization layer 313 may also include the fourth protrusion and/or the groove, the orthographic projection of the fourth protrusion and/or the orthographic projection of the groove on the substrate is located between the orthographic projections of the adjacent first protrusions on the substrate.

Because the first pixel definition layer 3141 is disposed on the side that is of the planarization layer 313 and that is away from the substrate 10, in a case in which the planarization layer 313 includes the groove, a pattern of the first pixel definition layer 3141 disposed on the side that is of the planarization layer 313 and that is away from the substrate 10 corresponds to the groove of the planarization layer 313, and also includes the groove. In addition, the orthographic projection of the groove on the substrate 10 is located between the orthographic projections of the adjacent first protrusions on the substrate 10. In this way, if some rays passing through the first protrusion are still not emitted from the first pixel definition layer 3141 and used for display, the some rays may further propagate along the groove of the first pixel definition layer 3141, break a horizontal propagation angle again by using the groove, and are emitted from the display panel 3 and used for display, to further improve display brightness of the display panel 3.

In some possible implementations, sub-pixel regions 1011 of different colors have different light-emitting efficiency. For example, the sub-pixel region 1011 includes a red sub-pixel region, a green sub-pixel region, and a blue sub-pixel region, and light-emitting efficiency of the blue sub-pixel region is less than light-emitting efficiency of the red sub-pixel region and light-emitting efficiency of the green sub-pixel region. Therefore, in this embodiment of this application, a taper angle of the second protrusion close to the blue sub-pixel region may be further increased, so that after being reflected by the anode 3121, the ray is emitted from the display panel 3 at a small angle and used for display. This can improve brightness of blue light viewed from a front-view angle.

Further, a person skilled in the art should know that a larger taper angle of the second protrusion indicates greater brightness attenuation of the sub-pixel region 1011 close to the second protrusion. In other words, when the display panel 3 is viewed from the front, the viewed display brightness is high. However, when the display panel 3 is viewed from a side, brightness of a high-angle ray emitted from the display panel 3 is greatly reduced, affecting user experience.

In view of this, in this embodiment of in this application, further, an area of the blue sub-pixel region may be greater than an area of the red sub-pixel region and an area of the green sub-pixel region. In this way, brightness of blue light can be improved. In addition, because the area of the blue sub-pixel region is large, a high-angle ray emitted from the middle part of the blue sub-pixel region may be directly emitted at a large angle and used for display, and is not emitted to the first pixel definition layer 3141. Therefore, all rays emitted from the middle part of the blue sub-pixel region are not affected by the taper angle of the second protrusion, and brightness of the ray emitted from the middle part of the blue sub-pixel region is not attenuated.

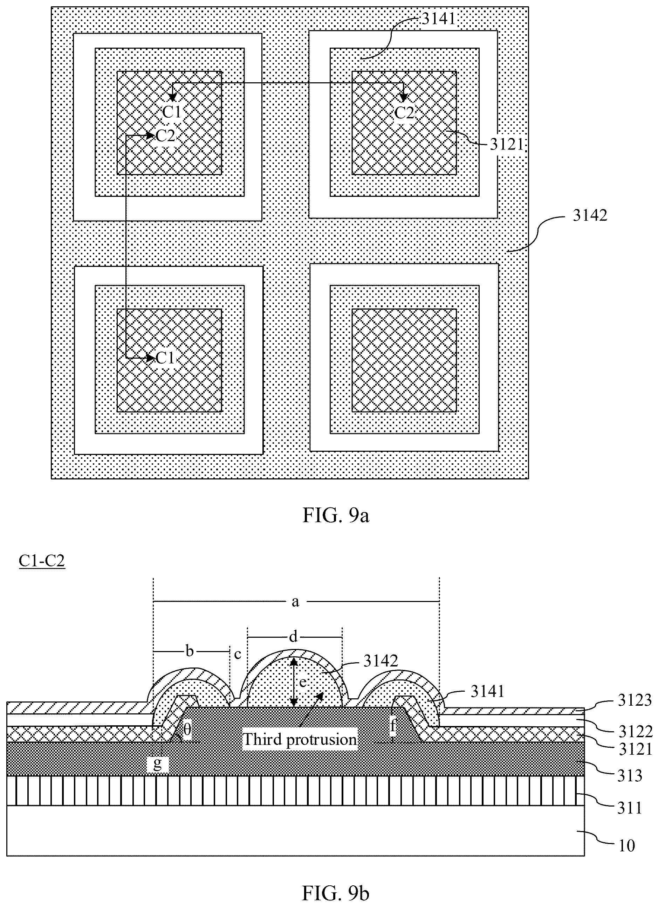

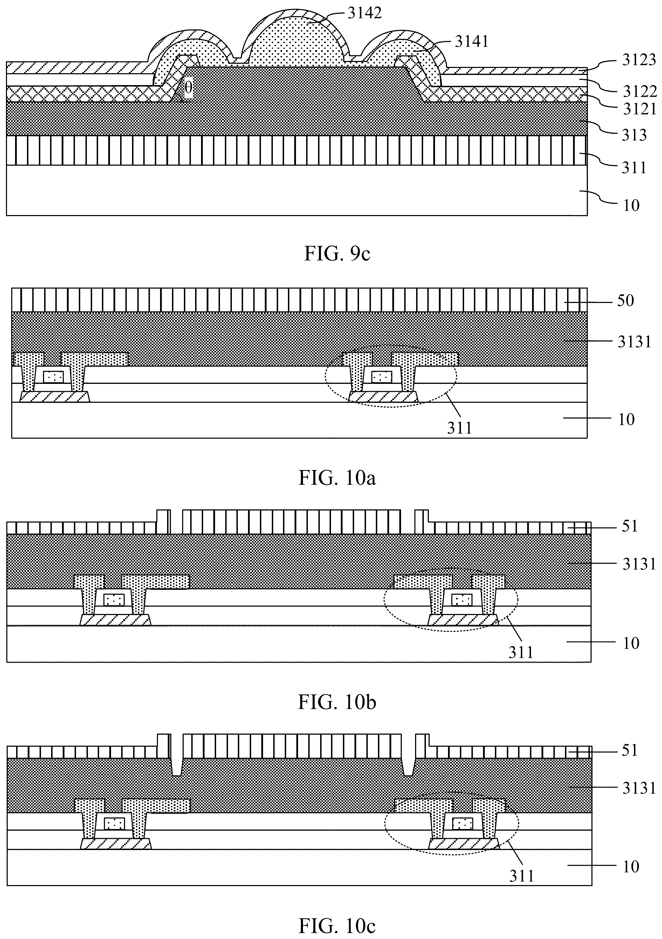

In some embodiments, as shown in FIG. 9a to FIG. 9c, an overlapping region exists between an orthographic projection of the first protrusion on the substrate 10 and an orthographic projection of an anode 3121 adjacent to the first protrusion on the substrate 10. The array base plane 31 further includes a second pixel definition layer 3142, the second pixel definition layer 3142 includes a third protrusion, and the third protrusion is disposed between the adjacent first protrusions. A width of the first protrusion is less than a width of the third protrusion in the direction from the any one of the sub-pixel regions 1011 to the sub-pixel region 1011 adjacent to the any one sub-pixel region 1011, and a thickness of the first protrusion is less than a thickness of the third protrusion in the direction from the substrate 10 to the first pixel definition layer 3141.

In this way, the first protrusion has a small width and a small thickness, so that a distance between a light-emitting layer 3122 and the side surface of the anode 3121 can be reduced, to avoid a case in which because the distance between the light-emitting layer 3122 and the side surface of the anode 3121 is excessively large, some rays cannot be reflected by the side surface of the anode 3121 and used for display. Through simulation calculation, compared with EQE of an existing structure, EQE of the structure in this embodiment of this application can be increased by at least 17.2%.

The array base plane 31 may be prepared by using the following steps:
In a first case, a material of a planarization layer 313 is a non-photosensitive material.

As shown in FIG. 10a, a planarization thin film 3131 and a photoresist 50 are formed on a substrate 10 on which a thin film transistor 311 is formed.

As shown in FIG. 10b, the photoresist 50 is half-tone exposed and developed to obtain a first photoresist pattern 51. The first photoresist pattern 51 includes a fully-reserved part, a half-reserved part, and a completely-removed part. The completely-reserved part corresponds to a to-be-formed second protrusion, the completely-removed part corresponds to a via in the to-be-formed planarization layer 313, and the half-reserved part corresponds to another area of the planarization thin film 3131.

As shown in FIG. 10c, under protection of the first photoresist pattern 51, the planarization thin film 3131 is partially etched to obtain a planarization pattern 3132. A thickness of a part that is of the planarization pattern 3132 and that is located at a to-be-formed via is greater than 0, and is less than a thickness of another part of the planarization pattern 3132.

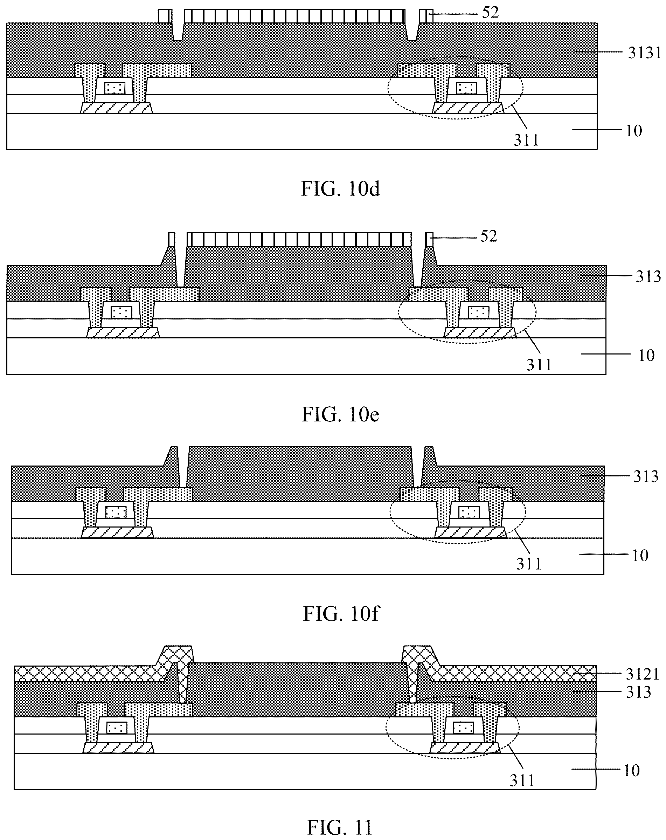

As shown in FIG. 10d, the half-reserved part in the first photoresist pattern 51 is removed to obtain a second photoresist pattern 52. For example, the half-reserved part in the first photoresist pattern 51 may be removed by using an ashing process.

As shown in FIG. 10e, under protection of the second photoresist pattern 52, the planarization pattern 3132 is etched to obtain the planarization layer 313. The planarization layer 313 includes a second protrusion and a via.

Then, as shown in FIG. 10f, the second photoresist pattern 52 is removed.

In a second case, a material of a planarization layer 313 includes a photosensitive material. For example, the material of the planarization layer 313 is the same as a material of a positive photoresist.

After a planarization thin film 3131 is formed on a substrate 10 on which a thin film transistor 311 is formed, the planarization thin film 3131 is exposed by using a mask (mask). The mask includes a completely light-transmitting region, a partially light-transmitting region, and an opaque region. The fully light-transmitting region corresponds to a to-be-formed via in the planarization layer 313, the opaque region corresponds to a to-be-formed second protrusion in the planarization layer 313, and the partially light-transmitting region corresponds to another part in the planarization layer 313. The planarization layer 313 is obtained through development.

In the second case, the planarization layer 313 is prepared by using a half-tone (half-tone) process and one mask (mask). Certainly, in some other possible implementations, the planarization layer 313 may be alternatively prepared by using two masks.

Then, as shown in FIG. 11, an anode 3121 may be further formed on the planarization layer 313 by using processes such as film formation, exposure, development, and etching. An edge of the anode 3121 may extend from a side surface of the second protrusion to a side that is of the second protrusion and that is away from the substrate 10, and the anode 3121 is electrically connected to a drain of the thin film transistor 311 through the via.

Then, with reference to FIG. 7a to FIG. 7d, a first pixel definition layer 3141 and a second pixel definition layer 3142 are formed on the substrate 10. A material of the first pixel definition layer 3141 and a material of the second pixel definition layer 3142 each include a photosensitive material. For example, the material of the first pixel definition layer 3141 and the material of the second pixel definition layer 3142 are the same as the material of the positive photoresist. A plurality of patterns of the first pixel definition layer 31411 and the second pixel definition layer 3142 may be obtained by using film formation, exposure, and development in a same semiconductor process. In this way, the first pixel definition layer 3141 and the second pixel definition layer 3142 that have different patterns may be prepared by using a same mask, and an etching process may be omitted.

Specifically, after a pixel definition thin film is formed, the pixel definition thin film is exposed. During exposure, an opening of the mask corresponds to a part of the pixel definition thin film except a to-be-formed first protrusion and a to-be-formed third protrusion. In addition, because a width of the third protrusion is greater than a width of the first protrusion, when the pixel definition thin film is exposed, impact on the to-be-formed first protrusion is greater than impact on the to-be-formed third protrusion, and a thickness of the first protrusion obtained after development is also less than a thickness of the third protrusion. That is, the first pixel definition layer 3141 and the second pixel definition layer 3142 can be obtained by exposing the pixel definition thin film by using only one mask.

Optionally, as shown in FIG. 9b, in a direction from any one sub-pixel region 1011 to a sub-pixel region 1011 adjacent to the any one sub-pixel region 1011, a range a of a width between adjacent light-emitting layers 3122 may be 10 µm to 30 µm, a range b of a width of the first protrusion may be 2 µm to 10 µm, a range c of a spacing between an adjacent first protrusion and the third protrusion may be 1 µm to 6 µm, a range d of a width of the third protrusion may be 3 µm to 24 µm, and a range g of a distance from a light-emitting layer 3122 to the side surface of the anode 3121 may be 0.5 µm to 5 µm. A range e of a thickness of the third protrusion may be 1 µm to 4 µm, and a range f of a thickness of the second protrusion may be 0.3 µm to 3 µm.

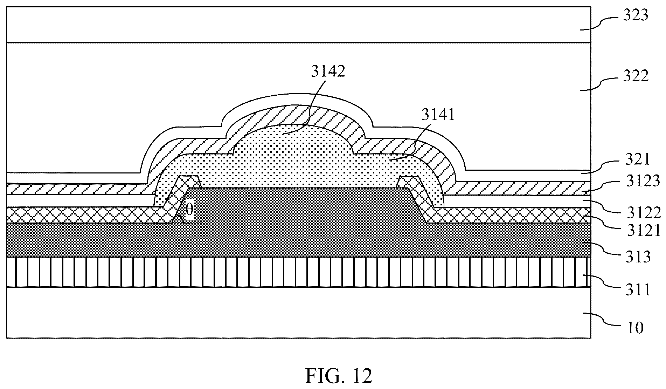

In some possible implementations, as shown in FIG. 12, there are two first protrusions, there is one third protrusion, and the two first protrusions and the third protrusion are continuously disposed. A surface that is of the first protrusion and that is away from the substrate 10 includes a first surface and an inclined second surface, the first surface is parallel to a horizontal surface, and a surface that is of the third protrusion and that is away from the substrate 10 is connected to the first surface.

An overlapping region exists between an orthographic projection of the first protrusion and an orthographic projection of an anode 3121 adjacent to the first protrusion on the substrate 10, and the anode extends from a sub-pixel region 1011 and the side surface of the second protrusion to the side that is of the second protrusion and that is away from the substrate 10. In this way, the first protrusion also needs to incline from the side surface of the anode 3121 to a side that is of the anode 3121 and that is away from the substrate 10, where an inclined surface of the first protrusion is the second surface. In view of this, because a surface that is of the second protrusion in the planarization layer 313 and that is away from the substrate 10 may be a plane, and the first protrusion is disposed on the side that is of the second protrusion and that is away from the substrate 10, in addition to the inclined second surface, a surface that is of the first protrusion and that is away from the substrate 10 includes the first surface parallel to the horizontal surface.

For a solution in which a plurality of first protrusions are spaced apart, or a plurality of first protrusions are spaced apart and the first protrusion and the third protrusion are also spaced apart, in a process of preparing the first protrusion and the third protrusion by using a same semiconductor process, many patterns need to be patterned, and during mask-based exposure, parts that are of a mask and that correspond to a spacing between the protrusions are an opening. However, in this application, the first protrusion may be obtained based on a pattern of the second protrusion. In addition, because the first surface is parallel to the horizontal plane, and the first surface is connected to the third protrusion, for example, the first protrusion and the third protrusion are prepared by using a half-tone process, during first exposure, the opening of the mask corresponds to an area other than the to-be-formed first pixel definition layer 3141 and the to-be-formed second pixel definition layer 3142 in the array base plane 31, and during second exposure, the opening of the mask may correspond to a part other than the third protrusion. Compared with a solution in which the plurality of first protrusions are spaced apart, or the plurality of first protrusions are spaced apart and the first protrusion and the third protrusion are also spaced apart, this solution in this application greatly reduces a quantity of openings in the mask, so that a process yield rate of preparing the first protrusion and the third protrusion can be improved.

In another embodiment, an embodiment of this application further provides a display panel 3. As shown in FIG. 4a to FIG. 4e, the display panel 3 includes an encapsulation layer 32 and the array base plane 31 described in any one of the foregoing embodiments. The array base plane 31 further includes a light-emitting layer 3122 and a cathode 3123 that are disposed on a substrate 10, a first pixel definition layer 3141 is disposed between adjacent light-emitting layers 3122, and the cathode 3123 is disposed between the first pixel definition layer 3141 and the encapsulation layer 32. In a direction from the substrate 10 to the first pixel definition layer 3141, the encapsulation layer 32 includes a first inorganic encapsulation layer 321 and an organic encapsulation layer 322 that are sequentially stacked, where a refractive index of the first inorganic encapsulation layer 321 is greater than a refractive index of the organic encapsulation layer 322, and patterns of parts that are of the cathode 3123 and the first inorganic encapsulation layer 321 and that overlap a first protrusion correspond to a pattern of the first protrusion.

The cathode 3123 and the first inorganic encapsulation layer 321 may be disposed on a side that is of the first pixel definition layer 3141 and that is away from the substrate 10, and thicknesses of the cathode 3123 and the first inorganic encapsulation layer 321 are usually small. Therefore, the patterns of the parts that are of the cathode 3123 and the first inorganic encapsulation layer 321 and that overlap the first protrusion correspond to the pattern of the first protrusion, and the part that is of the first inorganic encapsulation layer 321 and that overlaps the first protrusion may also include a plurality of protrusions. In one aspect, surfaces that are of the cathode 3123 and the first inorganic encapsulation layer 321 and that are away from the substrate 10 in this application are more uneven than those of a cathode 3123 and a first inorganic encapsulation layer 321 in a related technology. In this case, after a ray is incident to the cathode 3123 and the first inorganic encapsulation layer 321, and then is propagated in a waveguide mode through the cathode 3123 and the first inorganic encapsulation layer 321 (where an optical path is indicated by dashed arrows in FIG. 4b), the ray is likely to be emitted from the uneven cathode 3123 and the uneven first inorganic encapsulation layer 321, so that more rays are used for display. In another aspect, after the ray is incident to the first inorganic encapsulation layer 321, the ray is no longer incident from the first inorganic encapsulation layer 321 to the organic encapsulation layer 322 at a single angle, but is incident to the organic encapsulation layer 322 at different angles based on a shape of a protrusion in the first encapsulation layer 321 (where an optical path is indicated by dashed arrows in FIG. 4b), so that total reflection that occurs when the ray is incident from the first inorganic encapsulation layer 321 to the organic encapsulation layer 322 can be improved, and more rays incident from the first inorganic encapsulation layer 321 to the organic encapsulation layer 322 are free from total reflection. This improves display brightness of the display panel without increasing power consumption of the display panel.

In some possible implementations, refractive indexes of the first inorganic encapsulation layer 321 and the organic encapsulation layer 322 are not limited in embodiments of this application, and the refractive indexes of the first inorganic encapsulation layer 321 and the organic encapsulation layer 322 are related to their materials. Optionally, the refractive index of the first inorganic encapsulation layer 321 may range from 1.75 to 1.85, and the refractive index of the organic encapsulation layer 322 may range from 1.48 to 1.5.

In some possible implementations, the first pixel definition layer 3141 may be in direct contact with the first inorganic encapsulation layer 321; or another structure may be disposed between the first pixel definition layer 3141 and the first inorganic encapsulation layer 321, provided that a pattern of the part that is of the first inorganic encapsulation layer 321 and that overlaps the first protrusion of the array base plane 31 corresponds to the pattern of the first protrusion.

In addition, other explanations, descriptions, and beneficial effects of embodiments of this application are the same as those of the foregoing embodiments. Details are not described herein again.

In still another embodiment, an embodiment of this application further provides a method for preparing an array base plane 31. The array base plane 31 has a plurality of sub-pixel regions 1011. The method for preparing an array base plane includes: forming a first pixel definition layer 3141 on a substrate 10. As shown in FIG. 4a to FIG. 4e, the first pixel definition layer 3141 is disposed between adjacent sub-pixel regions 1011, and the first pixel definition layer 3141 includes a plurality of first protrusions in a direction from any one of the sub-pixel regions 1011 to a sub-pixel region 1011 adjacent to the any one sub-pixel region 1011.

Further, as shown in FIG. 10a to FIG. 10e, before the pixel definition layer 314 is formed, a planarization layer 313 may be further formed on the substrate 10. The planarization layer 313 includes a third protrusion, a taper angle of the third protrusion is a non-right angle, and a side surface of the second protrusion gradually tilts from an anode 3121 to the planarization layer 313 in a direction from the substrate 10 to the planarization layer 313.

Specifically, as shown in FIG. 10a, a planarization thin film 3131 and a photoresist 50 are formed on the substrate 10 on which the thin film transistor 311 is formed.

As shown in FIG. 10b, the photoresist 50 is half-tone exposed and developed to obtain a first photoresist pattern 51. The first photoresist pattern 51 includes a fully-reserved part, a half-reserved part, and a completely-removed part. The completely-reserved part corresponds to the to-be-formed second protrusion, the completely-removed part corresponds to a via in the to-be-formed planarization layer 313, and the half-reserved part corresponds to another area of the planarization thin film 3131.

As shown in FIG. 10c, under protection of the first photoresist pattern 51, the planarization thin film 3131 is partially etched to obtain a planarization pattern 3132. A thickness of a part that is of the planarization pattern 3132 and that is located at a to-be-formed via is greater than 0, and is less than a thickness of another part of the planarization pattern 3132.

As shown in FIG. 10d, the half-reserved part in the first photoresist pattern 51 is removed to obtain a second photoresist pattern 52. For example, the half-reserved part in the first photoresist pattern 51 may be removed by using an ashing process.

As shown in FIG. 10e, under protection of the second photoresist pattern 52, the planarization pattern 3132 is etched to obtain the planarization layer 313. The planarization layer 313 includes the second protrusion and the via.

Then, as shown in FIG. 10f, the second photoresist pattern 52 is removed.

In the foregoing steps, the planarization layer 313 is prepared by using a half-tone process and one mask. Certainly, in some other possible implementations, the planarization layer 313 may be alternatively prepared by using two masks.

Then, as shown in FIG. 11, the anode 3121 may be further formed on the planarization layer 313 by using processes such as film formation, exposure, development, and etching. An edge of the anode 3121 may extend from a side surface of the second protrusion to a side that is of the third protrusion and that is away from the substrate 10, and the anode 3121 is electrically connected to a drain of the thin film transistor 311 through the via. The anode 3121 extends from the sub-pixel region 1011 and the side surface of the second protrusion to a side that is of the second protrusion and that is away from the substrate 10.

Because the anode 3121 extends from the sub-pixel region 1011 and the side surface of the second protrusion to the side that is of the second protrusion and that is away from the substrate 10, a tilt angle of a part that is of the anode 3121 and that corresponds to a side surface of the third protrusion is the same as the taper angle θ of the third protrusion, and is also a non-right angle, and a side surface of the anode 3121 gradually tilts from the anode 3121 to the planarization layer 313 in the direction from the substrate 10 to the planarization layer 313.

In some possible implementations, a taper angle θ of the second protrusion is not limited in embodiments of this application, provided that the taper angle θ of the second protrusion is a non-right angle. In this way, some high-angle rays projected onto the side surface of the anode 3121 may be further reflected by the anode 3121 to a display panel 3 and used for display, to improve display brightness of the display panel 3.

For example, the taper angle θ of the second protrusion may range from 5° to 85°. For example, the taper angle θ of the second protrusion may be 5°, 20°, 45°, 60°, or 85°.

Optionally, the taper angle of the second protrusion may range from 20° to 60°, to avoid a case in which a film layer (for example, a cathode) disposed on a side that is of the first pixel definition layer 3141 and that is away from the substrate 10 is broken because the taper angle θ of the second protrusion is excessively large.

In some possible implementations, when forming the first pixel definition layer 3141 on the substrate 10, the method for preparing an array base plane further includes: forming a second pixel definition layer 3142. The second pixel definition layer 3142 includes a third protrusion, the third protrusion is disposed between adjacent first protrusions, a width of the first protrusion is less than a width of the third protrusion in the direction from the any one of the sub-pixel regions 1011 to the sub-pixel region 1011 adjacent to the any one sub-pixel region 1011, and a thickness of the first protrusion is less than a thickness of the third protrusion in a direction from the substrate 10 to the first pixel definition layer 3141.

In this way, the first protrusion has a small width and a small thickness, so that a distance between a light-emitting layer 3122 and the side surface of the anode 3121 can be reduced, to avoid a case in which because the distance between the light-emitting layer 3122 and the side surface of the anode 3121 is excessively large, some rays cannot be reflected by the side surface of the anode 3121 and used for display.

In some possible implementations, the first pixel definition layer 3141 and the second pixel definition layer 3142 each include a photosensitive material. For example, a material of the first pixel definition layer 3141 and a material of the second pixel definition layer 3142 are the same as a material of a positive photoresist. Patterns of the first pixel definition layer 3141 and the second pixel definition layer 3142 may be obtained by using film formation, exposure, and development in a same semiconductor process. In this way, the first pixel definition layer 3141 and the second pixel definition layer 3142 that have different patterns may be prepared by using a same mask, and an etching process may be omitted.

Specifically, after a pixel definition thin film is formed, the pixel definition thin film is exposed. During exposure, an opening of a mask corresponds to a part of the pixel definition thin film except a to-be-formed first protrusion and a to-be-formed third protrusion. In addition, because the width of the third protrusion is greater than the width of the first protrusion, when the pixel definition thin film is exposed, impact on the to-be-formed first protrusion is greater than impact on the to-be-formed third protrusion, and the thickness of the first protrusion obtained after development is also less than the thickness of the third protrusion. That is, the first pixel definition layer 3141 and the second pixel definition layer 3142 can be obtained by exposing the pixel definition thin film by using only one mask.

In addition, other explanations, descriptions, and beneficial effects of embodiments of this application are the same as those of the foregoing embodiments. Details are not described herein again.

The foregoing describes embodiments of this application with reference to the accompanying drawings. However, this application is not limited to the foregoing specific implementations. The foregoing specific implementations are merely examples instead of limitations. Inspired by this application, a person of ordinary skill in the art may further make modifications without departing from the purposes of this application and the protection scope of the claims, and all the modifications shall fall within the protection of this application.

## Claims

1. An array base plane, wherein the array base plane has a plurality of sub-pixel regions, and the array base plane comprises a substrate and a first pixel definition layer disposed on the substrate; and
the first pixel definition layer is disposed between adjacent sub-pixel regions, and the first pixel definition layer comprises a plurality of first protrusions in a direction from any one of the sub-pixel regions to a sub-pixel region adjacent to the any one sub-pixel region.

2. The array base plane according to claim 1, wherein adjacent first protrusions are spaced apart; and
in a direction from the substrate to the first pixel definition layer, a thickness of a part that is of the first pixel definition layer and that is located between adjacent first protrusions is less than a thickness of the first protrusion, wherein
the thickness of the part that is of the first pixel definition layer and that is located between the adjacent first protrusions is greater than or equal to 0.

3. The array base plane according to claim 2, wherein surfaces that are of the plurality of first protrusions and that are away from the substrate are arc surfaces; and/or
the part that is of the first pixel definition layer and that is located between the adjacent first protrusions is a pit, and a surface that is of the pit and that is away from the substrate is an arc surface.

4. The array base plane according to any one of claims 1 to 3, wherein the array base plane further comprises a planarization layer and an anode, the planarization layer is disposed between the substrate and the first pixel definition layer, and the anode is located in the sub-pixel region;
the planarization layer comprises a second protrusion, the second protrusion is disposed between adjacent anodes, a taper angle of the second protrusion is a non-right angle, and a side surface of the second protrusion gradually tilts from the anode to the planarization layer in a direction from the substrate to the planarization layer; and
the anode extends from the sub-pixel region and the side surface of the second protrusion to a side that is of the second protrusion and that is away from the substrate.

5. The array base plane according to claim 4, wherein an overlapping region exists between an orthographic projection of the first protrusion on the substrate and an orthographic projection of the anode adjacent to the first protrusion on the substrate;
the array base plane further comprises a second pixel definition layer, the second pixel definition layer comprises a third protrusion, and the third protrusion is disposed between the adjacent first protrusions; and
a width of the first protrusion is less than a width of the third protrusion in the direction from the any one of the sub-pixel regions to the sub-pixel region adjacent to the any one sub-pixel region; and a thickness of the first protrusion is less than a thickness of the third protrusion in the direction from the substrate to the first pixel definition layer.

6. The array base plane according to claim 5, wherein the first pixel definition layer and the second pixel definition layer each comprise a photosensitive material.

7. The array base plane according to claim 5 or 6, wherein there are two first protrusions, there is one third protrusion, and the two first protrusions and the third protrusion are continuously disposed; and
a surface that is of the first protrusion and that is away from the substrate comprises a first surface and an inclined second surface, the first surface is parallel to a horizontal surface, and a surface that is of the third protrusion and that is away from the substrate is connected to the first surface.

8. The array base plane according to any one of claims 4 to 7, wherein an acute angle of a taper angle of the second protrusion ranges from 5° to 85°.

9. The array base plane according to any one of claims 4 to 8, wherein the side surface of the second protrusion is in a shape of a sawtooth.

10. The array base plane according to claim 2 or 3, wherein the array base plane further comprises a planarization layer, and the planarization layer is disposed between the substrate and the first pixel definition layer; and
in a case in which the thickness of the part that is of the first pixel definition layer and that is located between the adjacent first protrusions is greater than 0, the planarization layer comprises a fourth protrusion and/or a groove, and an orthographic projection of the fourth protrusion and/or an orthographic projection of the groove on the substrate are/is located between orthographic projections of the adjacent first protrusions on the substrate.

11. The array base plane according to claim 10, wherein a surface that is of the fourth protrusion and/or the groove and that is away from the substrate is an arc surface.

12. The array base plane according to any one of claims 1 to 11, wherein the sub-pixel region comprises a red sub-pixel region, a green sub-pixel region, and a blue sub-pixel region; and
a taper angle of the first protrusion close to the blue sub-pixel region is greater than a taper angle of the first protrusion close to the red sub-pixel region and the green sub-pixel region.

13. The array base plane according to claim 12, wherein an area of the blue sub-pixel region is greater than an area of the red sub-pixel region and an area of the green sub-pixel region.

14. A display panel, comprising an encapsulation layer and the array base plane according to any one of claims 1 to 13, wherein the array base plane further comprises a light-emitting layer and a cathode that are disposed on a substrate, a first pixel definition layer is disposed between adjacent light-emitting layers, and the cathode is disposed between the first pixel definition layer and the encapsulation layer; and
in a direction from the substrate to the first pixel definition layer, the encapsulation layer comprises a first inorganic encapsulation layer and an organic encapsulation layer that are sequentially stacked, wherein a refractive index of the first inorganic encapsulation layer is greater than a refractive index of the organic encapsulation layer, and patterns of parts that are of the cathode and the first inorganic encapsulation layer and that overlap a first protrusion correspond to a pattern of the first protrusion.

15. The display panel according to claim 14, wherein the refractive index of the first inorganic encapsulation layer ranges from 1.75 to 1.85, and the refractive index of the organic encapsulation layer ranges from 1.48 to 1.5.

16. The display panel according to claim 14 or 15, wherein the encapsulation layer further comprises a second inorganic encapsulation layer; and
the first inorganic encapsulation layer, the organic encapsulation layer, and the second inorganic encapsulation layer are sequentially stacked in a direction from the substrate to the light-emitting device.

17. A terminal device, wherein the terminal device comprises a frame body, a cover plate, and the display panel according to any one of claims 14 to 16, and the display panel is disposed in space enclosed by the frame body and the cover plate.

18. A method for preparing an array base plane, wherein the array base plane has a plurality of sub-pixel regions; and the method for preparing an array base plane comprises:
forming a first pixel definition layer on a substrate, wherein the first pixel definition layer is disposed between adjacent sub-pixel regions, and the first pixel definition layer comprises a plurality of first protrusions in a direction from any one of the sub-pixel regions to a sub-pixel region adjacent to the any one sub-pixel region.

19. The method for preparing an array base plane according to claim 18, wherein before forming the first pixel definition layer, the method for preparing an array base plane further comprises:
sequentially forming a planarization layer and an anode on the substrate, wherein the planarization layer comprises a second protrusion, the second protrusion is disposed between adjacent anodes, a taper angle of the second protrusion is a non-right angle, a side surface of the second protrusion gradually tilts from the anode to the planarization layer in a direction from the substrate to the planarization layer, the anode is located in the sub-pixel region, and the anode extends from the sub-pixel region and the side surface of the second protrusion to a side that is of the second protrusion and that is away from the substrate.

20. The method for preparing an array base plane according to claim 19, wherein when forming the first pixel definition layer on the substrate, the method for preparing an array base plane further comprises:
forming a second pixel definition layer, wherein the second pixel definition layer comprises a third protrusion, the third protrusion is disposed between adjacent first protrusions, a width of the first protrusion is less than a width of the third protrusion in the direction from the any one of the sub-pixel regions to the sub-pixel region adjacent to the any one sub-pixel region, and a thickness of the first protrusion is less than a thickness of the third protrusion in a direction from the substrate to the first pixel definition layer.
